(19) Europäisches Patentamt

European Patent Office

Office européen des brevets

(11) **EP 1 035 649 A2**

(12) **EUROPEAN PATENT APPLICATION**

(43) Date of publication:
**13.09.2000 Bulletin 2000/37**

(51) Int. Cl.⁷: **H03J 7/18**

(21) Application number: **00105092.1**

(22) Date of filing: **10.03.2000**

(84) Designated Contracting States:
**AT BE CH CY DE DK ES FI FR GB GR IE IT LI LU MC NL PT SE**
Designated Extension States:
**AL LT LV MK RO SI**

(30) Priority: **10.03.1999 JP 6298699**

(71) Applicant: **Pioneer Corporation**
**Meguro-ku, Tokyo (JP)**

(72) Inventor:
**Nakamura, Shigeki,**
**Kawagoe Koujou,**
**Pioneer Corpor.**
**Kawagoe-shi, Saitama-ken 350-8555 (JP)**

(74) Representative:
**Sajda, Wolf E., Dipl.-Phys. et al**
**MEISSNER, BOLTE & PARTNER**
**Postfach 86 06 24**
**81633 München (DE)**

(54) **Communication method and apparatus for performing multichannel transmission**

(57)    Disclosed are a communication apparatus which performs multichannel transmission by executing preprocessing for searching for an adequate channel for communications from a plurality of channels (CH1-CHN) assigned to a radio frequency band and then setting a normal communication state, and a communication method for use in such a communication apparatus. The communication apparatus comprises a control section (16) for generating an instruction signal (S1, S2) for tuning to frequencies of channel candidates and one or more frequencies in the vicinity of the frequencies of the channel candidates; a reception section (1; 2, 3) having a specific selection characteristic, for tuning to the frequencies of the channel candidates (CH1-CHN) and the one or more frequencies in the vicinity of the frequencies of the channel candidates (CH1-CHN) in accordance with the instruction signal (S1, S2); a measuring section (13, 15) for measuring a reception strength (RSSI) of a signal (Sx) produced from a received signal by the reception section (1; 2, 3); and a decision section (15, 16, 17) for determining whether or not received signals of the channel candidates (CH1-CHN) are adequate for communications based on reception strengths (RSSI) of the received signals.

FIG.1

## Description

### BACKGROUND OF THE INVENTION

### FIELD OF THE INVENTION

The present invention relates to a communication method and apparatus adapted for use in a communication system which performing multichannel transmission, and, more particularly, to a communication method and apparatus which can quickly and accurately search multiple channels for the channel that is adequate for communications.

### DESCRIPTION OF THE RELATED ART

One example of conventional communication apparatuses of this type is known as a so-called portable telephone which is used in a mobile communication system. Mobile communication systems in Japan use a TDM (Time Division Multiplex) system for a communication from a base station to a mobile station (down-link) and use a TDMA (Time Division Multiple Access) system for a communication from the mobile station to the base station (up-link).

The 800 MHz band and 1500 MHz band are assigned as available radio frequency bands. The carrier frequency interval is 25 kHz with an interleave of 50 kHz. The transmission/reception frequency intervals are 130 MHz and 55 MHz for the 800 MHz band and 48 MHz for the 1500 MHz band.

For communications with the base station using a portable telephone, preprocessing for searching for a communicatable channel is performed with the base station. Specifically, after preprocessing for searching multiple channels assigned to the radio frequency bands for an adequate channel for communications is executed, the normal communication state for that channel is set.

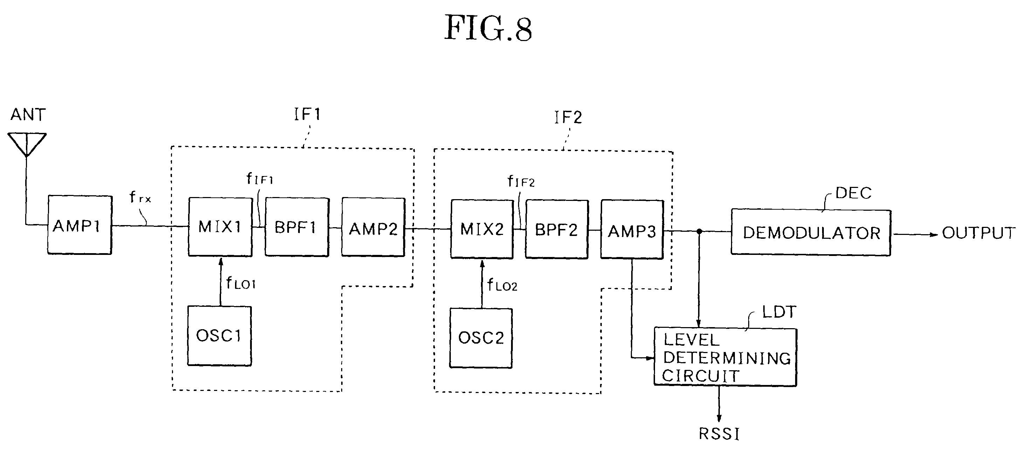

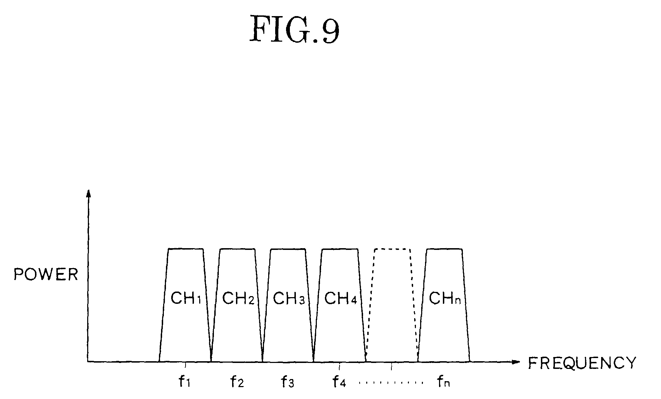

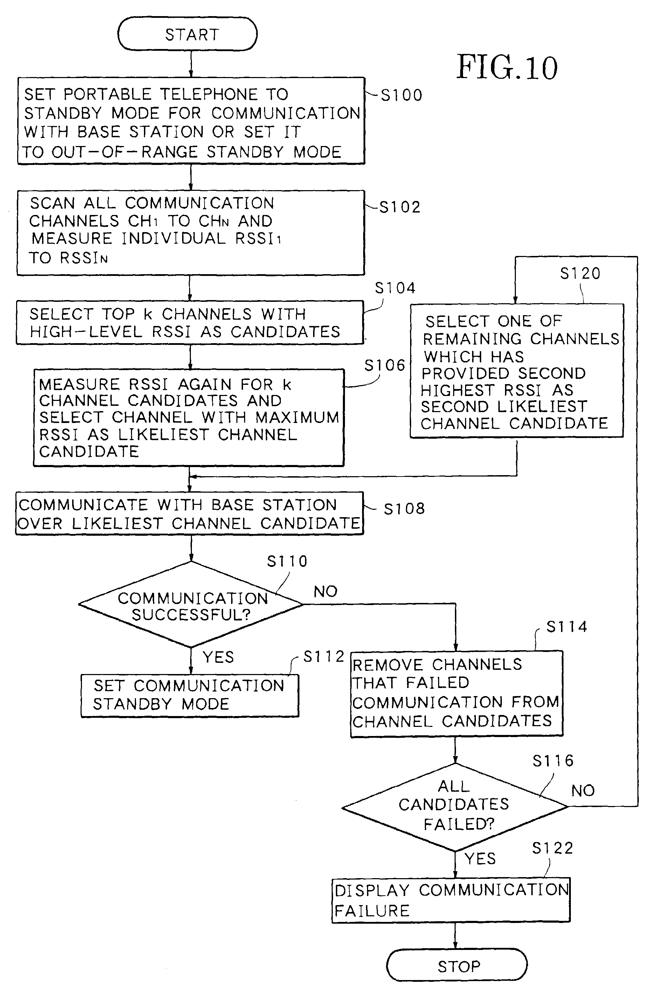

FIG. 8 is a block diagram showing the essential structure of a conventional portable telephone, and FIGS. 9 and 10 are explanatory diagrams illustrating the preprocessing. In FIG. 8, the portable telephone takes the structure of a super heterodyne reception system equipped with two stages of frequency converting sections IF1 and IF2.

An amplifier AMP1 amplifies radio waves from the base station received by an antenna ANT, yielding a high-frequency signal of a frequency $f_{rx}$. The first stage of frequency converting section IF1 causes a mixer MIX1 to mix the high-frequency signal of the frequency $f_{rx}$ with a local oscillation signal of a frequency $f_{L01}$ generated by a local oscillator OSC1. This results in the down-conversion of the high-frequency signal to an intermediate frequency $f_{IF1} = |f_{rx} - f_{L01}|$. The frequency converting section IF1 then sends out this intermediate frequency $f_{IF1}$ through a band-pass filter BPF1 having a predetermined pass band and an amplifier AMP2.

The second stage of frequency converting section IF2 causes a mixer MIX2 to mix the intermediate frequency $f_{IF1}$ down-converted in the first frequency converting section 1F1 with a local oscillation signal of a frequency $f_{L02}$ generated by a local oscillator OSC2. This causes the intermediate frequency $f_{IF1}$ to be down-converted to a lower intermediate frequency $f_{IF2} = |f_{IF1} - f_{L02}|$. The frequency converting section IF2 then sends this intermediate frequency $f_{IF2}$ to a demodulator (demodulation circuit) DEC through a band-pass filter BPF2 having a predetermined pass band and an amplifier AMP3 having an AGC (Automatic Gain Control) function.

The above conventional preprocessing is carried out in accordance with a flowchart illustrated in FIG. 10. First, the portable telephone is set to a mode to standby for communications with the base station or to an out-of-range standby mode (step S100). Next, the channel frequencies $f_1$ to $f_N$ of all of channels $CH_1$ to $CH_N$ as shown in FIG. 9 that are assigned to the portable telephone are sequentially scanned by receiving the radio waves from the base station and changing the frequency $f_{L01}$ of the local oscillator OSC1, and further received-signal strength indexes $RSSI_1$ to $RSSI_N$ at the time a level determining circuit LDT receives the individual channel frequencies $f_1$-$f_N$ are then determined based on the signal level output from the amplifier AMP3 (step S102).

In step S104, top $\underline{k}$ (e.g., 5) channels in all the channels $CH_1$-$CH_N$ which have provided high-level received-signal strength indexes (RSSI) are selected as channel candidates. Then, the aforementioned scanning is performed again on those top $\underline{k}$ channel candidates, and one channel that provides the highest RSSI is determined as the most likely candidate (likeliest channel candidate) in step S106.

Then, the frequency $f_{L01}$ of the local oscillator OSC1 is set for the reception of the likeliest channel candidate, and a communication with the base station is actually attempted (step S108), and it is determined if the communication is successful (step S110). If no communication can be established even after a predetermined time, e.g., 10 seconds, the communication is considered as failed.

When the communication with the base station is successful, the preprocessing is terminated and the flow proceeds to step S112 to set the communication standby mode with the likeliest channel candidate.

When the communication with the base station is unsuccessful, on the other hand, the processes in steps S114-S120, S108 and S110 are repeated. That is, when the communication with the base station failed, the channel that has resulted in a communication failure is eliminated from the candidates (step S114), it is checked if there is any remaining channel candidate (step S116), and the channel that has provided the second highest RSSI is set as the second likeliest channel candidate (step S120).

Then, the processes in steps S108 and S110 are performed. The above-described process loop is repeated until the communication with the base station succeeds. If a communication failure occurs even through the preprocessing performed on all the channel candidates, the flow goes to step S122 from step S116 to display the communication final failure after which this routine is terminated.

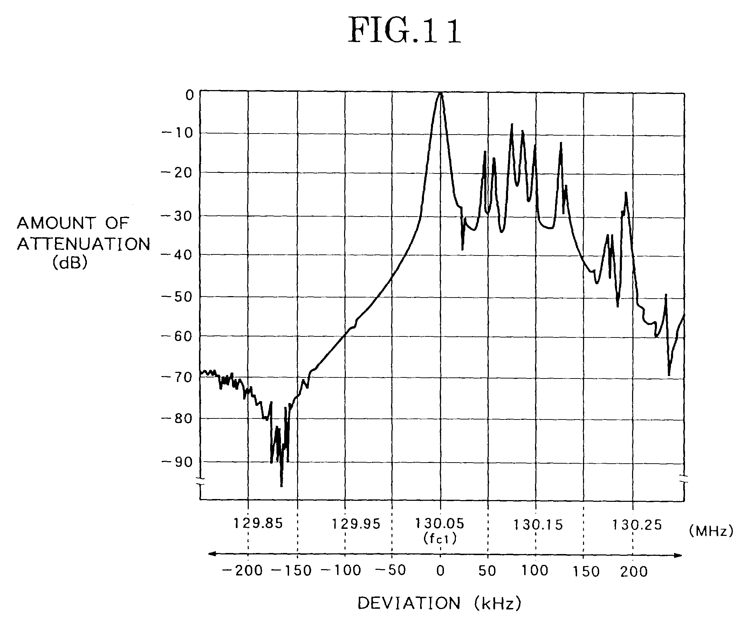

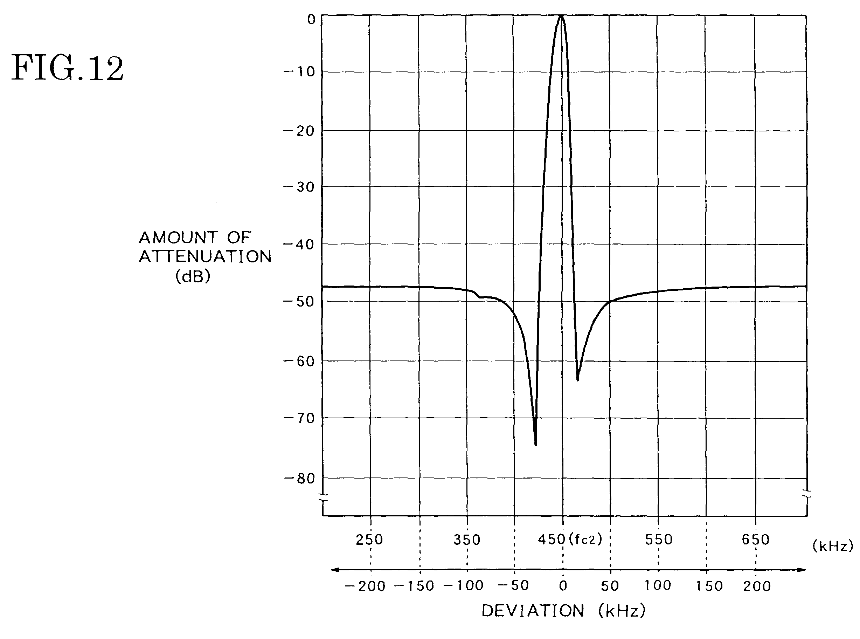

A crystal filter which has a frequency characteristic as shown in FIG. 11 is used as the band-pass filter BPF1 in the first frequency converting section IF1. A ceramic filter having a frequency characteristic as shown in FIG. 12 is used as the band-pass filter BPF2 in the second frequency converting section IF2.

In FIGS. 11 and 12, the vertical scales represent the amount of attenuation and the horizontal scales represent frequency deviations with respect to center frequencies $f_{c1}$ and $f_{c2}$.

As apparent from FIG. 11, the crystal filter has an asymmetrical frequency characteristic which shows large attenuation in a frequency band lower than the center frequency $f_{c1}$ (e.g., the carrier frequency of 130.05 MHz) and gentle attenuation in a frequency band higher than the center frequency $f_{c1}$. As apparent from FIG. 12, the ceramic filter has an approximately symmetrical frequency characteristic which shows high $\underline{Q}$ at the center frequency $f_{c2}$ (e.g., 450 kHz). The degree of channel separation, the noise-resistance characteristic and the like are determined by the total frequency characteristic shown in FIG. 13 that is acquired based on the center frequencies $f_{c1}$ and $f_{c2}$ of the crystal filter and ceramic filter.

As the frequency characteristic of the crystal filter is asymmetrical, the total frequency characteristic also becomes asymmetrical with respect to the center frequencies $f_{c1}$ and $f_{c2}$. As a result, even with the conventional preprocessing done, it may be difficult to search for the adequate communication channel fast and accurately.

According to the conventional preprocessing, the individual channels are scanned, yielding received-signal strength indexes (RSSI), and the channel that provides the highest RSSI is determined as the adequate channel. If an interference of a large level exists in the region higher than the center frequency $f_{c1}$, $f_{c2}$ (the frequency region showing gentle attenuation) in the total frequency characteristic, therefore, the interference cannot be reduced sufficiently. This may result in that the channel which provides a high received-signal strength index (RSSI) due to the influence of the interference is erroneously determined as the adequate channel.

Even if such an erroneous decision is made, the conventional preprocessing makes an actual attempt to establish a communication with the base station based on the wrong channel that has been erroneously determined as the adequate one to inspect the result of the decision reliably. If the inspection proves that the decision was in error, however, the conventional preprocessing takes much time to search for a new channel candidate. Because of this shortcoming, there have been demands for the development of communication apparatuses that can search for a channel adequate for communications faster and more precisely.

## SUMMARY OF THE INVENTION

Accordingly, it is an object of the present invention to provide a communication method and apparatus which can quickly and accurately search multiple channels for the channel that is adequate for communications.

To achieve the above object, according to one aspect of this invention, there is provided a communication apparatus for performing multichannel transmission, which comprises a control section for generating an instruction signal for tuning to frequencies of channel candidates and one or more frequencies in a vicinity of the frequencies of the channel candidates; a reception section having a specific selection characteristic, for tuning to the frequencies of the channel candidates and the one or more frequencies in a vicinity of the frequencies of the channel candidates in accordance with the instruction signal; a measuring section for measuring a reception strength of a signal produced from a received signal by the reception section; and a decision section for determining whether or not received signals of the channel candidates are adequate for communications based on reception strengths of the received signals.

With this structure, when the reception strength of the received signal that is obtained when a channel candidate is received is greater than the reception strength obtained at the time of receiving a neighboring frequency by a predetermined value or by more than the predetermined value, for example, this channel candidate is determined as adequate for communications. Using this selected channel can ensure adequate communications with the base station.

This communication apparatus may be designed in such a way that a bandwidth of the frequency region in which the amount of attenuation is smaller (the attenuation characteristic is poor) is wider than a selected bandwidth in a close vicinity of the center frequency; each of the one or more frequencies in a vicinity of the frequencies of the channel candidates is a frequency which has provided an associated one of the channel candidates with such a frequency difference that a difference in reception strength caused by a difference between the bandwidths can be detected; and when the difference in reception strength is equal to or greater than a predetermined value, the decision section determines that a received signal of the associated channel candidate is likely to be adequate for communications.

With this structure, the communication apparatus determines if the characteristic of the reception section in the frequency band that shows smaller attenuation is poor in addition to the decision on whether or not the signal received when the channel candidate was received is on the center frequency of the reception section, i.e., whether or not the received signal is a signal of the channel candidate.

Specifically, if shifting the frequency of the received signal by the aforementioned frequency difference results in a significant change in the reception strength of the received signal, it is possible to accurately determine that the signal received when the channel candidate was received is tuned to the center frequency of the reception section. Further, if the reception strength of the received signal changes significantly by shifting the frequency of the received signal by the aforementioned frequency difference, it is possible to determine that the characteristic of the reception section in the frequency band that shows smaller attenuation is excellent.

The communication apparatus may also be modified in such a manner that each of the one or more frequencies in a vicinity of the frequencies of the channel candidates is acquired by subtracting a difference between a bandwidth of the frequency region in which the amount of attenuation is smaller and the center frequency from a frequency of an associated one of the channel candidates; and when a reception strength of a received signal of each of the one or more frequencies in a vicinity of the frequencies of the channel candidates is higher than that of a received signal of the frequency of the associated channel candidate by a predetermined value or by more than the predetermined value, the decision section determines that the received signal of the associated channel candidate is adequate for communications.

With this structure, if shifting the frequency of the channel candidate with respect to the center frequency of the reception section changes the reception strength of the received signal acquired then, it is determined that the selection of the channel candidate is affected by the interference and the channel candidate may not be adequate for communications.

The communication apparatus may also be modified in such a way that each of the one or more frequencies in a vicinity of the frequencies of the channel candidates is acquired by adding a difference between a bandwidth of the frequency region in which the amount of attenuation is smaller and a bandwidth of the other frequency region to a frequency of an associated one of the channel candidates; and when a reception strength of a received signal of each of the one or more frequencies in a vicinity of the frequencies of the channel candidates is lower than that of a received signal of the frequency of the associated channel candidate by a predetermined value or by more than the predetermined value, the decision section determines that the received signal of the associated channel candidate is not likely to be adequate for communications.

With this structure, when the tuned frequency is shifted so that the region where the attenuation characteristic of the reception section is good is shifted to the region which shows low attenuation and when the reception strength of the received signal acquired then changes, it is determined that the selection of the channel candidate is affected by the interference and the channel candidate is unlikely to be adequate for communications.

According to another aspect of this invention, there is provided a communication apparatus for performing multichannel transmission, which comprises a control section for executing a predetermined system program and generating an instruction signal for tuning to frequencies of channel candidates and one or more frequencies in a vicinity of the frequencies of the channel candidates; a reception section having a specific selection characteristic, for tuning to the frequencies of the channel candidates and the one or more frequencies in a vicinity of the frequencies of the channel candidates in accordance with the instruction signal; a plurality of frequency converting sections including a first frequency converting section for converting a frequency of a signal received by the reception section to a first intermediate frequency and a second frequency converting section for converting the first intermediate frequency to a second intermediate frequency lower than the first intermediate frequency and outputting a signal indicating a reception level; a level determining circuit for determining whether or not received signals of the channel candidates are adequate for communications based on the reception-level indicating signal; and a memory for storing various kinds of data at a time the control section performs preprocessing.

According to a further aspect of this invention, there is provided a communication method for use in a communication system for performing multichannel transmission by executing preprocessing for searching for an adequate channel for communications from multiple channels assigned to a radio frequency band and then setting a normal communication state, which method comprises the steps of generating an instruction signal for tuning to frequencies of channel candidates and one or more frequencies in a vicinity of the frequencies of the channel candidates; tuning to the frequencies of the channel candidates and the one or more frequencies in a vicinity of the frequencies of the channel candidates in accordance with a specific selection characteristic and the instruction signal; measuring a reception strength of a signal produced from a received signal; and determining whether or not received signals of the channel candidates are adequate for communications based on reception strengths of the received signals.

## BRIEF DESCRIPTION OF THE DRAWINGS

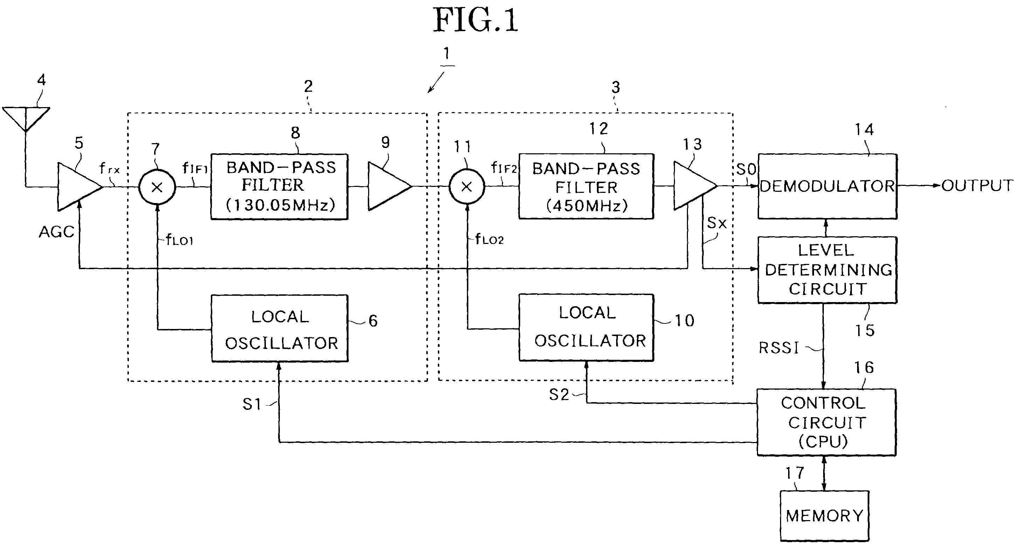

FIG. 1 is a block diagram showing the essential structure of a communication apparatus according to one embodiment of this invention;

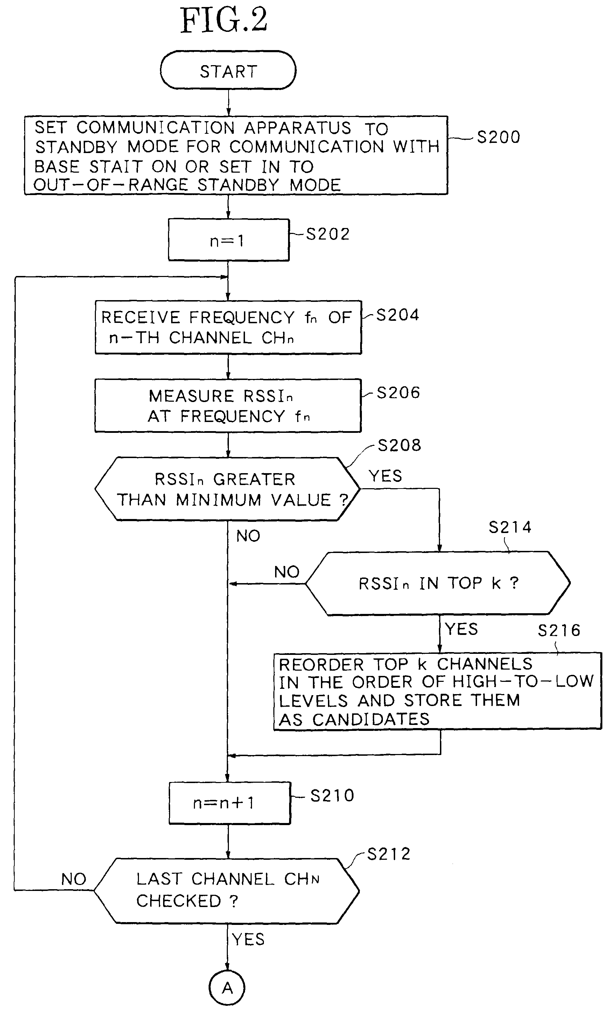

FIG. 2 is a flowchart for explaining the operation of the communication apparatus according to this embodiment;

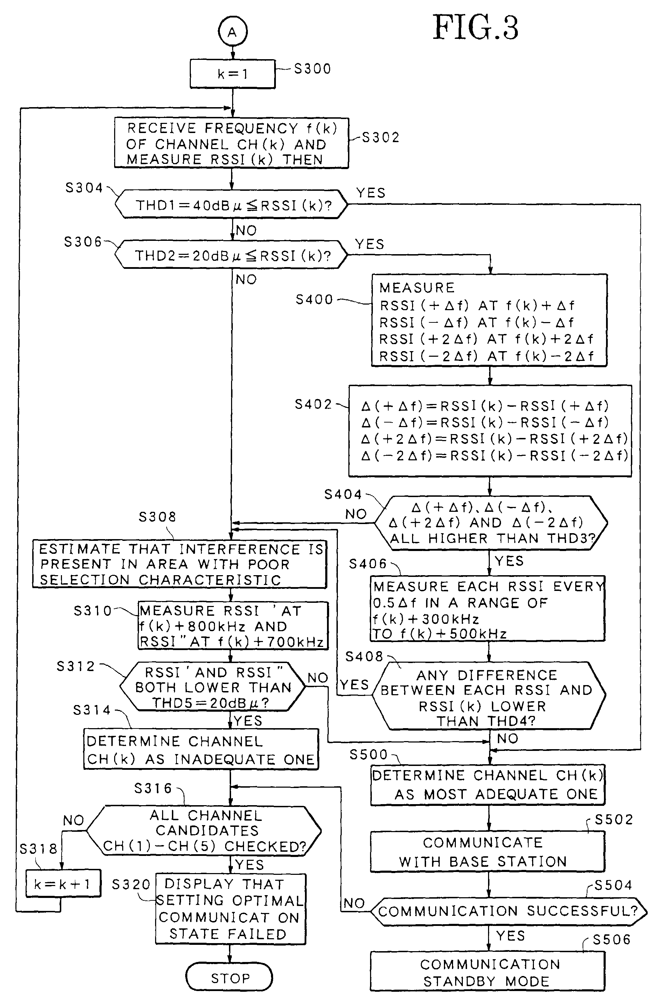

FIG. 3 is a flowchart for further explaining the operation of the communication apparatus according to this embodiment;

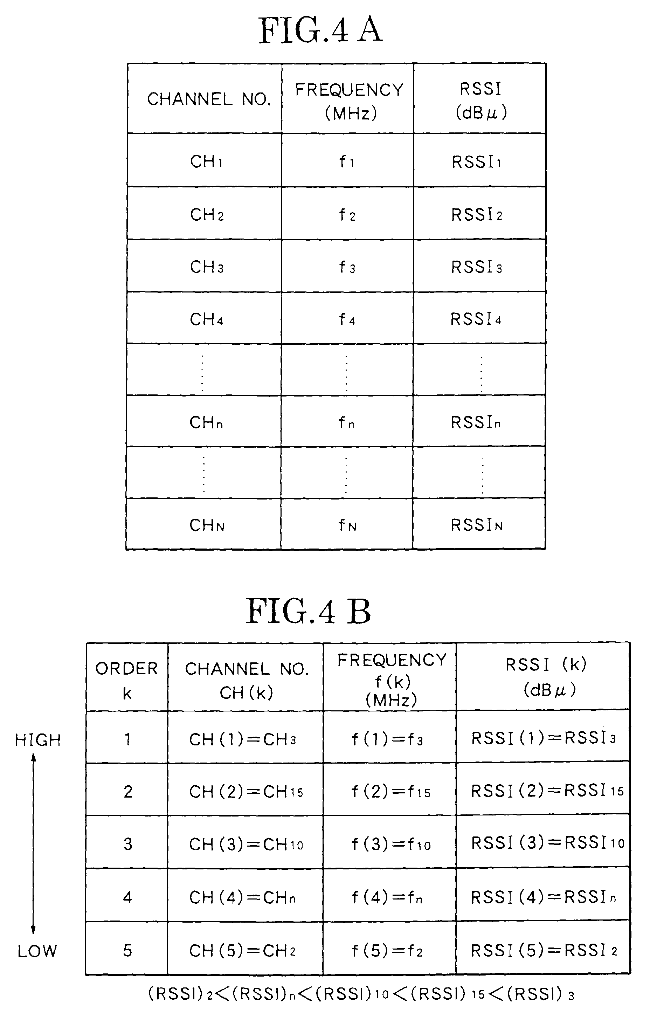

FIG. 4 is an explanatory diagram showing data about channel candidates to be stored in a memory equipped in the communication apparatus of this embodiment;

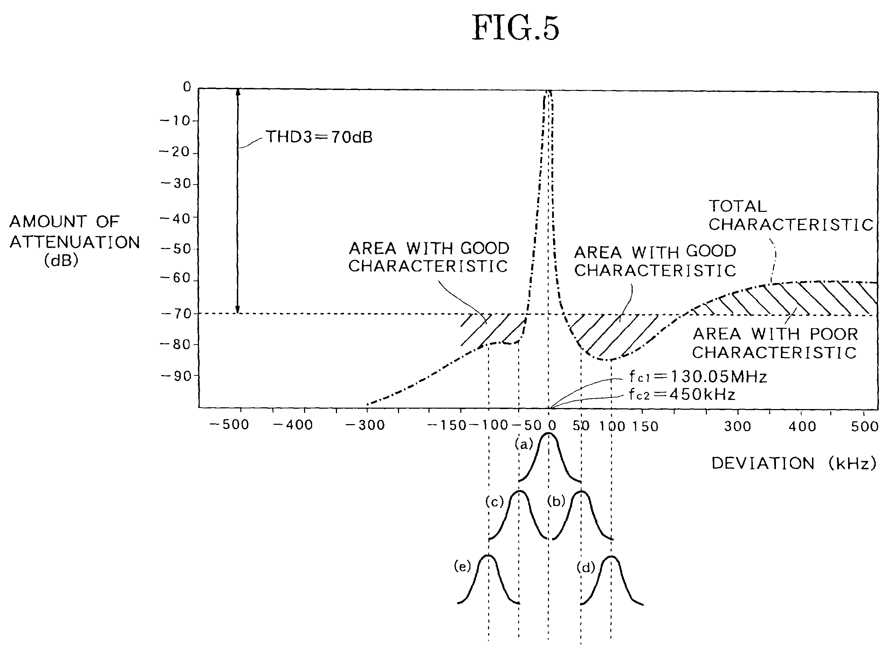

FIG. 5 is an explanatory diagram illustrating the center frequencies set at the time of selecting a channel candidate adequate for communications in contrast to the total attenuation characteristic of filters;

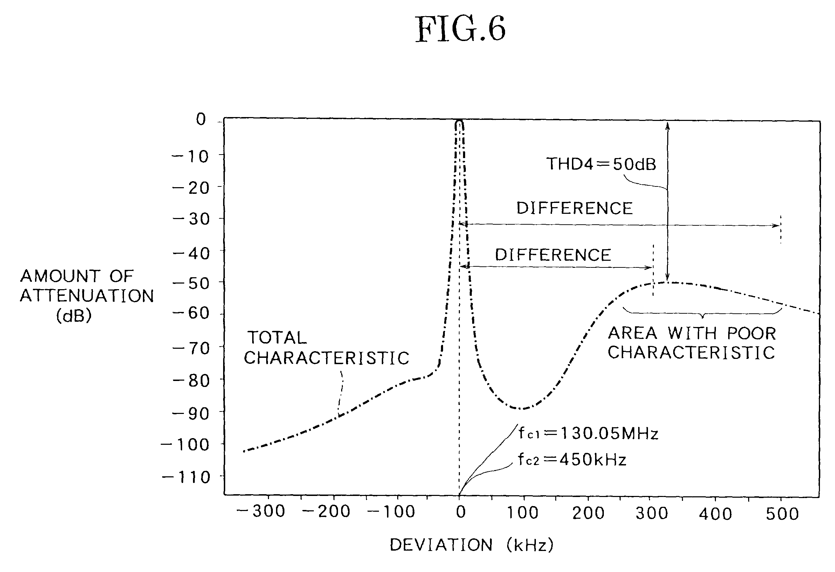

FIG. 6 is an explanatory diagram illustrating the center frequencies set for inspection of the influence of interference at the time of selecting a channel candidate adequate for communications in contrast to the total attenuation characteristic of filters;

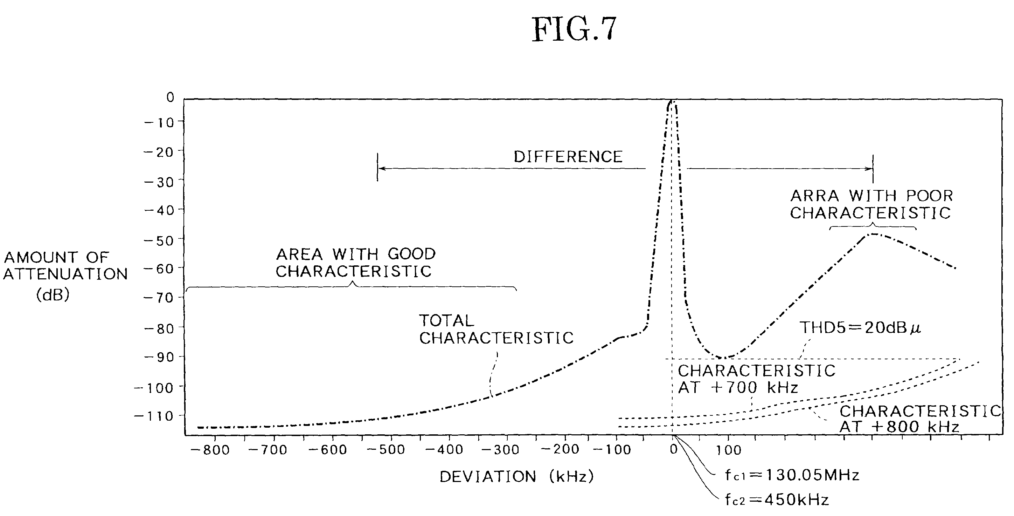

FIG. 7 is an explanatory diagram illustrating the center frequencies set for further inspection of the influence of interference at the time of selecting a channel candidate adequate for communications in contrast to the total attenuation characteristic of filters;

FIG. 8 is a block diagram schematically showing the structure of a conventional communication apparatus;

FIG. 9 is an explanatory diagram for explaining the operation of selecting channel candidates in the conventional communication apparatus;

FIG. 10 is an explanatory diagram for further explaining the operation of selecting channel candidates in the conventional communication apparatus;

FIG. 11 is a characteristic diagram showing the frequency characteristic of a crystal filter;

FIG. 12 is a characteristic diagram showing the frequency characteristic of a ceramic filter; and

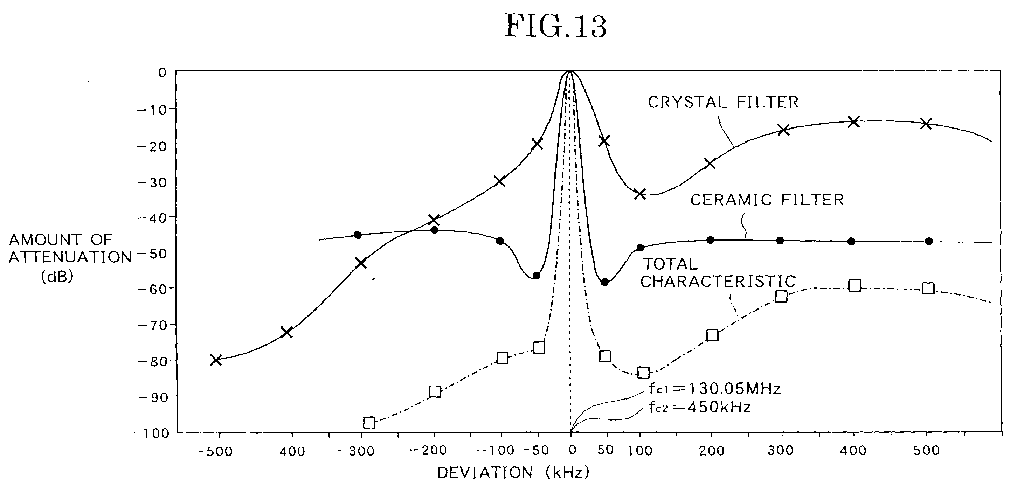

FIG. 13 is a characteristic diagram illustrating the total attenuation characteristics of the crystal filter and ceramic filter.

## DETAILED DESCRIPTION OF THE PREFERRED EMBODIMENTS

A communication apparatus which is provided in a portable telephone for a mobile communication system according to one preferred embodiment of the present invention will now be described with reference to the accompanying drawings. FIG. 1 presents a block diagram showing the essential structure of a communication apparatus according to this embodiment, and FIGS. 2 through 4 present flowcharts and an explanatory diagram for explaining the operation of this communication apparatus.

Referring to FIG. 1, a reception section 1 of this communication apparatus has the structure of a super heterodyne reception system equipped with two stages of frequency converting sections 2 and 3.

The first-stage frequency converting section 2 comprises a local oscillator 6, a mixer 7, a band-pass filter 8 and an amplifier 9. The second-stage frequency converting section 3 comprises a local oscillator 10, a mixer 11, a band-pass filter 12 and an amplifier 13.

The local oscillator 6 is so designed as to generate a local oscillation signal of a frequency $f_{L01}$ which is designated by a control signal S1 from a control circuit 16.

An amplifier 5 amplifies radio waves from the base station received by an antenna 4, yielding a high-frequency signal of a frequency $f_{rx}$. The mixer 7 mixes the high-frequency signal of the frequency $f_{rx}$ with the local oscillation signal of the frequency $f_{L01}$ generated by the local oscillator 10. This results in the down-conversion of the high-frequency signal to an intermediate frequency $f_{IF1} = |f_{rx} - f_{L01}|$. Specifically, a signal of the high frequency $f_{rx}$ in a radio frequency band (e.g., 1500 MHz) which conforms to the radio equipment regulations is down-converted to the intermediate frequency $f_{IF1}$ of 130 MHz. This intermediate frequency $f_{IF1}$ is supplied to the band-pass filter 8.

The band-pass filter 8 is constructed by a crystal filter which has the frequency characteristic as shown in FIG. 11 and has a center frequency $f_{c1}$ of 130.05 MHz. The band-pass filter 8 passes the frequency component of 130.05 MHz in the down-converted intermediate frequency $f_{IF1}$ from the mixer 7.

The amplifier 9 amplifies the signal that has passed the band-pass filter 8 and sends the amplified signal to the second-stage frequency converting section 3.

The local oscillator 10 in the second-stage frequency converting section 3 is so designed as to generate a local oscillation signal of a frequency $f_{L02}$ which is designated by a control signal S2 from the control circuit 16.

The mixer 11 to mix the intermediate frequency $f_{IF1}$ down-converted in the first frequency converting section 2 and the local oscillation signal of the frequency $f_{L02}$ generated by the local oscillator 10. This results in the down-conversion of the intermediate frequency $f_{IF1}$ to a lower intermediate frequency $f_{IF2} = |f_{IF1} - f_{L02}|$. Specifically, a signal of the intermediate frequency $f_{IF1}$ (= 130 MHz) is down-converted to the intermediate frequency $f_{IF2}$ of 450 kHz. This intermediate frequency $f_{IF2}$ is supplied to the band-pass filter 12.

The band-pass filter 12 is constructed by a ceramic filter which has the frequency characteristic as shown in FIG. 12 and has a center frequency $f_{c2}$ of 450 MHz. The band-pass filter 12 passes the frequency component of 450 kHz in the intermediate frequency $f_{IF2}$.

The amplifier 13 amplifies the signal that has passed the band-pass filter 12, and sends the amplified signal or the amplified received signal (which has undergone TDM modulation), $S_0$, to a demodulator 14. The amplifier 13 also has an AGC (Automatic Gain Control) capability by which it generates a signal $S_x$ indicating the reception level of the antenna 4. The signal $S_x$ is then supplied to a level determining circuit 15 which will be discussed later. With the AGC capability, the amplifier 13 automatically controls its own amplification factor or gain and sends an AGC signal to the amplifier 15 to automatically control its gain.

This communication apparatus further includes the level determining circuit 15 and the control circuit 16 provided with a semiconductor memory 17. The level determining circuit 15 determines a received-signal strength index (RSSI) based on the signal $S_x$ supplied from the amplifier 13 and sends a signal representing the RSSI to the control circuit 16.

The control circuit 16 incorporates a microprocessor (CPU) which runs a preset system program to control preprocessing to be discussed later, the operation of the demodulator 14 and the general operation of the communication apparatus.

The memory 17 stores various kinds of data at the time the control circuit 16 performs preprocessing or the like.

The communication apparatus further includes a transmission section, though not illustrated in FIG. 1, which performs transmission to the base station via the antenna 4 under the control of the control circuit 16.

The operation of the thus-constituted communication apparatus at the time of performing preprocessing will now be described with referring to flowcharts in FIGS. 2 and 3.

Referring to FIG. 2, when preprocessing is initiated this communication apparatus is first set to a mode to standby for communications with the base station or to an out-of-range standby mode (step S200).

Next, the number of the first communication channel in all channels $CH_1$ to $CH_N$ assigned to the communication area is set to n = 1 (step S202). Then, the communication apparatus automatically adjusts the frequency $f_{L01}$ of the local oscillator 6 to the frequency that corresponds to the channel $CH_n$ with the number n = 1 and receives radio waves of a frequency $f_n$ over the channel $CH_n$ which are always transmitted from the base station (step S204). The individual frequencies $f_1$ to $f_N$ of the channels $CH_1$-$CH_N$ are separated from one another by a carrier frequency interval (25 kHz).

Next, the level determining circuit 15 determines the amplitude level of the received signal $S_0$ that has been produced by reception of radio waves over the channel $CH_n$ and sends a received-signal strength index $RSSI_n$ resulting from the measurement to the control circuit 16 (step S206).

In step S208, the acquired received-signal strength index $RSSI_n$ is compared with a predetermined minimum value for RSSI that can be used in communications. When the $RSSI_n$ is equal to or smaller than the minimum value, the flow proceeds to step S210. When the $RSSI_n$ is larger than the minimum value, the flow proceeds to step S214.

In step S210, the channel number is set to n = n + 1 to set the next channel. In the next step S212, it is determined whether or not the measurement of the received-signal strength indexes $RSSI_1$ to $RSSI_N$ for all the channels $CH_1$-$CH_N$ has been completed. If the measurement has not been completed yet, the sequence of processes starting from step S204 is repeated for the next channel $CH_n$ set in step S210.

That is, making the decisions in steps S210 and S212 can accomplish scanning for all the channels $CH_1$-$CH_N$. When scanning for all the channels $CH_1$-$CH_N$ is completed, the flow proceeds to step S300 shown in FIG. 3.

When the flow goes to step S214 from step S208, the latest received-signal strength index $RSSI_n$ acquired is stored in the memory 17 and it is determined if the $RSSI_n$ is among the top $\underline{k}$ (k = 5 in this embodiment) received-signal strength indexes stored as channel candidates in the memory 17. When the $RSSI_n$ is not present in the top k received-signal strength indexes, the flow proceeds to step S210 to set the channel number to n = n + 1.

When the $RSSI_n$ is found in the top k received-signal strength indexes, on the other hand, new top $\underline{k}$ received-signal strength indexes (RSSI) including the latest one are stored in the memory 17 as channel candidates in the order of levels. At this time, the one that is forced out of the group of the top $\underline{k}$ received-signal strength indexes is deleted. Then, the flow proceeds to step S210. The above-described loop process is repeated until scanning for all the channels $CH_1$-$CH_N$ is completed.

When the scanning routine illustrated in FIG. 2 is completed, the memory 17 holds data of the received-signal strength indexes $RSSI_1$-$RSSI_N$ in association with the frequencies $f_1$-$f_N$ of the individual channels $CH_1$-$CH_N$ as shown in FIG. 4A. Further, data of the top $\underline{k}$ (top five) levels of received-signal strength indexes $RSSI_n$ are stored in the memory 17 as channel candidates in accordance with the order $\underline{k}$ like RSSI(1) to RSSI(5) as shown in FIG. 4B. Furthermore, the top $\underline{k}$ channels $CH_n$ and their frequencies $f_n$ are likewise stored in the memory 17 in association with the order $\underline{k}$ like CH(1) to CH(5) and f(1) to f(5).

Because every time the latest received-sig-

nal strength index $RSSI_n$ is measured, the top $\underline{k}$ received-signal strength indexes are reordered, the data as shown in FIG. 4A need not be stored in the memory 17 in steps S214 and S216 in FIG. 2.

The steps S214 and S216 in FIG. 2 may be omitted in which case after it is determined in step S212 that scanning for all the channels $CH_1$-$CH_N$ is completed, the top $\underline{k}$ received-signal strength indexes $RSSI(1)$-$RSSI(5)$ are extracted from all the received-signal strength indexes $RSSI_1$-$RSSI_N$ and the data shown in FIG. 4B is formed. In this case, after the data shown in FIG. 4A is stored in the memory 17 and scanning for all the channels $CH_1$-$CH_N$ is completed, the top $\underline{k}$ received-signal strength indexes $RSSI(1)$-$RSSI(5)$ shown in FIG. 4B are stored in the memory 17 based on the data in FIG. 4A.

A description will now be given of the operation along the flowchart illustrated in FIG. 3. In step S300, the order $\underline{k}$ is set to k = 1 to select the channel CH(1) corresponding to the highest received-signal strength index $RSSI(1)$ shown in FIG. 4B and its frequency f(1). That is, the channel CH(1) which has provided the highest level of received-signal strength index $RSSI(1)$ is selected as an adequate communication channel candidate.

In the next step S302, the frequency $f_{L01}$ of the local oscillation signal from the local oscillator 6 is set in such a way as to receive a most likely or likeliest channel candidate CH(k) selected with k = 1. Further, the radio waves from the base station are actually received and the frequency converting sections 2 and 3 produce the intermediate frequencies $f_{IF1} = |f_{rx} - f_{L01}|$ and $f_{IF2} = |f_{IF1} - f_{L02}|$, respectively. Then, the level determining circuit 15 measures again the received-signal strength index $RSSI(k)$ of the received signal $S_0$ of the intermediate frequency $f_{IF2}$ output from the amplifier 13.

This will be discussed below more specifically. Assuming that a carrier frequency f(k) of the likeliest channel candidate CH(k) is 1489.05 MHz, the local oscillation frequency $f_{L01}$ of the local oscillator 6 is set to 1619.10 MHz to thereby set the intermediate frequency $f_{IF1}$ of the signal that is generated by the mixer 7 to 130.05 MHz equal to the center frequency $f_{c1}$ of the band-pass filter 8. The local oscillation frequency $f_{L02}$ of the local oscillator 10 should be fixed to 129.6 MHz (= 130.05 MHz - 450 kHz). This allows the peak of the spectrum of the signal of the intermediate frequency $f_{IF1}$, generated by the mixer 7, to match with the center frequencies $f_{c1}$ and $f_{c2}$ of the band-pass filters 8 and 12 as shown in FIG. 5A. Then, the received-signal strength index $RSSI(k)$ of the received signal $S_0$ obtained in this situation is acquired and it is checked again whether or not the likeliest channel candidate CH(k) is really adequate. If the data in FIG. 4B measured in the above-described preprocessing is used, step S302 may be omitted.

In the subsequent step S304, it is determined whether or not the remeasured received-signal strength index $RSSI(k)$ is equal to or larger than a threshold value THD1 predetermined as the lower limit of the level that is high enough for communications. In this embodiment, THD1 is set equal to 40 dBμ.

When the remeasured received-signal strength index $RSSI(k)$ is equal to or greater than 40 dBμ ("YES" in step S304), the flow proceeds to step S500. When the decision result is "NO", the flow goes to step S306.

In step S500, the reinspected likeliest channel candidate CH(k) is determined as suitable for communications. That is, it is determined that the frequency f(k) of the received channel CH(k) is surely located within the range of a carrier frequency interval of ±25 kHz around the center frequencies $f_{c1}$ and $f_{c2}$ of the total attenuation characteristic (see FIG. 13) acquired by the band-pass filters 8 and 12 and no interference with communications is present outside the range of ±25 kHz.

When this decision is made, a communication with the base station is attempted over the channel CH(k) in the next step S502. When it is determined in the subsequent step S504 that the communication with the base station has succeeded ("YES"), the flow proceeds to step S506 to set the standby mode for communications over that channel CH(k).

When the communication with the base station has failed ("NO") in step S504 although it was estimated that there would be no interference with communications, on the other hand, this channel is considered as inadequate for communications due to the influence of a stronger interference or some other factors. The flow then proceeds to step S316.

When the flow proceeds to step S306 from the aforementioned step S304, it is determined whether or not the remeasured received-signal strength index $RSSI(k)$ is equal to or larger than a threshold value THD2 predetermined as the lower limit of the level that is suitable for communications to some degree. In this embodiment, THD2 is set equal to 20 dBμ.

When the remeasured received-signal strength index $RSSI(k)$ is equal to or greater than 20 dBμ ("YES" in step S306), the flow proceeds to step S400. When the decision result is "NO", the flow goes to step S308.

In step S400, this communication apparatus commences a process of determining if the interference present in the frequency area above the center frequencies $f_{c1}$ and $f_{c2}$ of the total attenuation characteristic shown in FIG. 5 has made the received-signal strength index $RSSI(k)$ equal to or greater than 20 dBμ because the attenuation characteristic is poor in this frequency area.

First, the communication apparatus receives radio waves shifted by ±Δf and ±2Δf with respect to the frequency f(k) of the channel CH(k) and measures the received-signal strength index at each frequency.

Although the deviation of the frequency Δf is 50 kHz in this embodiment, a measurement may be taken every 25 kHz, which is the carrier frequency interval, to improve the precision.

This will be discussed below more specifically. Given that the carrier frequency f(k) of the channel CH(k) is 1489.05 MHz, the local oscillation frequency $f_{L01}$ of the local oscillator 6 is set to 1619.15 MHz to tune to the frequency component of 1489.10 MHz higher by Δf than the frequency f(k). Then, a signal of the intermediate frequency $f_{IF1}$ (= 130.05 MHz) in the radio waves of a frequency component of f(k) + Δf is generated as indicated by (b) in FIG. 5 and the received-signal strength index RSSI(*Δf) of the received signal $S_0$ acquired then is measured.

Further, with the local oscillation frequency $f_{L01}$ of the local oscillator 6 set to 1619.05 MHz, the mixer 7 generates a signal of the intermediate frequency $f_{IF1}$ (= 130.05 MHz) to receive the radio waves of a frequency f(k) - Δf (= 1489.00 MHz) as indicated by (c) in FIG. 5 and the received-signal strength index RSSI(-Δf) of the received signal $S_0$ acquired then is measured.

Furthermore, with the local oscillation frequency $f_{L01}$ of the local oscillator 6 set to 1619.20 MHz, the mixer 7 generates a signal of the intermediate frequency $f_{IF1}$ (= 130.05 MHz) to receive the radio waves of a frequency f(k) + 2Δf (= 1489.15 MHz) as indicated by (d) in FIG. 5 and the received-signal strength index RSSI(+2Δf) of the received signal $S_0$ acquired then is measured.

With the local oscillation frequency $f_{L01}$ set to 1618.90 MHz, the mixer 7 generates a signal of the intermediate frequency $f_{IF1}$ (= 130.05 MHz) to receive the radio waves of a frequency f(k) - 2Δf (= 1488.95 MHz) as indicated by (e) in FIG. 5 and the received-signal strength index RSSI(-2Δf) of the received signal $S_0$ acquired then is measured.

In step S402 are computed differences Δ(+Δf), Δ(-Δf), Δ(+2Δf) and Δ(-2Δf) between the received-signal strength index RSSI(k) measured for the carrier frequency f(k) and the respective received-signal strength indexes RSSI(+Δf), RSSI(-Δf), RSSI(+2Δf) and RSSI(-2Δf).

In the next step S404, it is determined if those differences Δ(+Δf), Δ(-Δf), Δ(+2Δf) and Δ(-2Δf) all become greater than a predetermined threshold value THD3. In this embodiment, THD3 is set equal to 70 dB.

When the differences Δ(+Δf), Δ(-Δf), Δ(+2Δf) and Δ (-2Δf) are all greater than the predetermined threshold value ("YES"), i.e., when an interference component whose frequency is close to the center frequencies and lies in the range with an excellent attenuation characteristic, it is determined that the poor attenuation characteristic in the frequency area above the center frequencies $f_{c1}$ and $f_{c2}$ of the total attenuation characteristic shown in FIG. 5 has made the received-signal strength index RSSI(k) equal to or greater than 20 dBμ.

That is, the threshold value THD3 = 70 dB is set to distinguish the frequency area with an excellent attenuation characteristic from the one with a poor attenuation characteristic, as shown in FIG. 5.

When the decision result in the step S404 is "YES", the processes in steps S406 and S408 are performed to determine whether or not an interference with communications is actually present in the frequency area with a poor attenuation characteristic.

In step S406, the received-signal strength index is measured for the intermediate frequency $f_{IF1}$ deviated by +300 kHz to +500 kHz from the center frequencies $f_{c1}$ and $f_{c2}$ as the frequency is shifted every Δf (= 50 kHz) as shown in FIG. 6. That is, the frequency in the frequency area with a poor attenuation characteristic is measured at the center portion of the selection characteristic.

More specifically, given that the frequency f(k) of the likeliest channel candidate CH(k) is 1489.05 MHz, radio waves in a range of 1489.35 MHz (= 1489.05 MHz + 0.30 MHz) to 1489.55 MHz (= 1489.05 MHz + 0.50 MHz) are received every Δf (= 50 kHz).

To accomplish this reception, the tuning frequencies which differ from one another by Δf (= 50 kHz) are acquired by changing the local oscillation frequency $f_{L01}$ of the local oscillator 6 at the time of reception by Δf (= 50 kHz) in the range of 1619.40 MHz to 1619.60 MHz.

Then, the received-signal strength indexes of the received signals $S_0$ produced then are measured.

In the subsequent step S408, the differences between the individual measured received-signal strength indexes and the received-signal strength index RSSI(k) that has been measured for the carrier frequency f(k) are obtained and it is determined if any of the differences is lower than a predetermined threshold value THD4. In this embodiment, this value THD4 corresponding to the amount of attenuation in the frequency area with a poor attenuation characteristic is set equal to 50 dB.

When none of the differences are lower than the threshold value THD4 ("NO"), it is determined again that the channel CH(k) is adequate for communications, after which the aforementioned processes of steps S500 to S504 are performed and the communication standby mode is set in step S506. That is, it is determined that no interference is present in the frequency area with a poor attenuation characteristic and the RSSI(k) is the received-signal strength index of a channel candidate. When the decision result in step S408 is "YES", on the other hand, it is determined that the RSSI(k) is influenced by some interference present in the frequency area with a poor attenuation characteristic.

As apparent from the above, the processes of steps S400 to S404 determine if the deterioration of the amount of attenuation of the crystal filter has raised any problem in the frequency area above the center frequencies $f_{c1}$ and $f_{c2}$ of the total attenuation characteristic shown in FIG. 5 and the processes of steps S406 and S408 determine if there is any interference in the frequency area with a poor attenuation characteristic shown in FIG. 6. This makes it possible to extremely accurately check if the likely channel candidate CH(k) is adequate for communications.

When the decision result in the step S306 or the step S404 is "NO" or the decision result in the step S408 is "YES", and the flow proceeds to step S308 as a consequence, it is estimated that the channel CH(k) selected as a likely candidate is influenced by some interference. Then, the flow proceeds to step S310 to carry out more accurate inspection.

In step S310, the tuning frequency is so deviated that the frequency area with a good attenuation characteristic comes to the area with a poor attenuation characteristic as shown in FIG. 7 and received-signal strength indexes RSSI' and RSSI" are measured. It is to be noted that the frequency to be deviated ranges from +800 kHz to +700 kHz in this embodiment.

More specifically, given that the frequency f(k) of the likeliest channel candidate CH(k) is 1489.85 MHz, the frequency is turned to 1489.85 MHz ( = 1489.05 MHz + 0.80 MHz ) to 1489.75 MHz ( = 1489.05 MHz + 0.70 MHz ). To accomplish this tuning, the local oscillation frequency $f_{L01}$ of the local oscillator 6 at the time of reception is set to 1618.30 MHz and 1618.40 MHz and the received-signal strength indexes RSSI' and RSSI" of the received signals $S_0$ acquired then are measured.

In the next step S312, it is determined if the RSSI' and RSSI" are both lower than a predetermined threshold value THD5. THD5 is set equal to 20 dBµ in this embodiment.

When both of the RSSI' and RSSI" are not lower than the threshold value THD5 ("NO"), it is estimated that the value RSSI(k) is not influenced by an interference in the frequency area with a poor attenuation characteristic and it is determined that a communication over the channel CH(k) selected as the likeliest candidate, if attempted, will not be influenced by any interference. Accordingly, the processes in steps S500 to S504 are performed and the communication standby mode is set in step S506.

When the decision result in step S312 is "YES", on the other hand, the flow proceeds to step S314 where it is determined that the channel CH(k) selected as the likeliest candidate is not adequate for communications. It is then determined in step S316 whether or not inspection for all the channel candidates CH(1)-CH(5) has been completed.

If no adequate channel is detected even when inspection for all the channel candidates CH(1)-CH(5) has been completed, a display or the like to the effect that no adequate communication could be set is made in step S320 after which the routine is terminated.

When it is determined in step S316 that inspection for all the channel candidates CH(1)-CH(5) has not been completed ("NO"), the number $\underline{k}$ is set to k + 1 in step S318 for inspection of the next channel candidate. Then, the above-described sequence of processes starting from step S302 is repeated.

According to this embodiment, as described above, after a predetermined number of channel candidates CH(1) to CH(5) are selected by the routine illustrated in the flowchart shown in FIG. 2, the inspection routine illustrated in the flowchart in FIG. 3 is carried out to find the channel that is most adequate for communications. This can permit such an adequate channel to be set at a very high precision.

When the total attenuation characteristics of the first-stage and second-stage band-pass filters 8 and 9 are asymmetric with respect to the center frequencies $f_{c1}$ and $f_{c2}$, particularly, executing steps S400-S408 and S308-S312 can ensure an automatic examination of whether a channel candidate is influenced by an interference, based on the total attenuation characteristics. As a result, an adequate channel is sought out.

Further, according to this embodiment, after a plurality of channel candidates are selected by the routine illustrated in the flowchart shown in FIG. 2, it is then checked if each channel candidate is really adequate for communications by the order k for that channel candidate. This can ensure faster selection of an adequate channel. When an adequate channel is found, no inspection is performed on the remaining channel candidates, thus shortening the time needed to search for a channel adequate for communications.

It is to be noted that the aforementioned threshold values THD1 to THD5 set as decision conditions are to be considered as illustrative and not restrictive and the invention is not to be limited to the details given herein. It is preferable to set the optimal threshold values in accordance with the frequency characteristic of the crystal filter, ceramic filter or the like in use.

Further, not all the above-described various decision steps need to be used. Alternatively, those decision steps may be carried out in the proper order or their combination may be changed as needed.

This invention is not limited to the use for compensating for the influence of the asymmetric total attenuation characteristic that is originated from the crystal filter, the ceramic filter or the like, and may be adapted to a communication apparatus which uses other filters as well.

Although this embodiment has been described as a communication apparatus which is adapted for use in a mobile communication system, this invention is in no way limited to such a communication apparatus. For example, this invention can be adapted to communication apparatuses for bidirectional optical fiber communication networks or the like which execute multichannel communications and multiplexed communications.

According to this invention, as apparent from the above, the frequency of a channel candidate is shifted by various frequency difference with respect to the center frequency that is set in the reception section and it is determined whether or not that channel candidate is adequate for communications based on a change in the reception strength of the received signal acquired then. This makes it possible to accurately search for an adequate channel candidate for communications.

Further, this scheme can automatically determine if there is any adverse influence originated from the asymmetrical frequency attenuation characteristic of the crystal filter or the like. When such an adverse influence is detected, it is possible to search the other channel candidates for a channel adequate for communications.

**Claims**

1. A communication apparatus for performing multichannel transmission, comprising:

    - a control section (16) for generating an instruction signal (S1, S2) for tuning to frequencies of channel candidates (CH1-CHN) and one or more frequencies in the vicinity of the frequencies of the channel candidates (CH1-CHN):
    - a reception section (1; 2, 3) having a specific selection characteristic, for tuning to the frequencies of the channel candidates (CH1-CHN) and the one or more frequencies in the vicinity of the frequencies of the channel candidates (CH1-CHN) in accordance with the instruction signal (S1, S2);
    - a measuring section (13, 15) for measuring a reception strength (RSSI(k)) of a signal (Sx) produced from a received signal by the reception section (1; 2, 3); and
    - a decision section (16, 17) for determining whether or not received signals of the channel candidates (CH1-CHN) are adequate for communications based on reception strengths (RSSI(k)) of the received signals.

2. The communication apparatus according to claim 1,
    wherein the selection characteristic of the reception section (1; 2, 3) is asymmetrical to a center frequency (fc1, fc2) and is such that an amount of attenuation in one frequency region with respect to the center frequency (fc1, fc2) is smaller than an amount of attenuation in the other frequency region with respect to the center frequency (fc1, fc2).

3. The communication apparatus according to claim 2,
    wherein a bandwidth of the frequency region, in which the amount of attenuation is smaller, is wider than a selected bandwidth in the close vicinity of the center frequency (fc1, fc2);
    wherein each of the one or more frequencies in the vicinity of the frequencies of the channel candidates (CH1-CHN) is a frequency which has provided an associated one of the channel candidates with such a frequency difference that a difference in reception strength caused by a difference between the bandwidths can be detected; and
    wherein the decision section (16, 17) determines that a received signal of the associated channel candidate (CH(k)) is likely to be adequate for communications when the difference in reception strength is equal to or greater than a predetermined value.

4. The communication apparatus according to claim 2,
    wherein each of the one or more frequencies in the vicinity of the frequencies of the channel candidates (CH1-CHN) is acquired by subtracting a difference between a bandwidth of the frequency region, in which the amount of attenuation is smaller, and the center frequency (fc1, fc2) from a frequency of an associated one of the channel candidates (CH1-CHN); and
    wherein the decision section (16, 17) determines that the received signal of the associated channel candidate (CH(k)) is adequate for communications when the reception strength of a received signal of each of the one or more frequencies in the vicinity of the frequencies of the channel candidates (CH1-CHN) is higher than that of a received signal of the frequency of the associated channel candidate by a predetermined value or by more than the predetermined value.

5. The communication apparatus according to claim 2,
    wherein each of the one or more frequencies in the vicinity of the frequencies of the channel candidates (CH1-CHN) is acquired by adding a difference between a bandwidth of the frequency region, in which the amount of attenuation is samller, and a bandwidth of the other frequency region to a frequency of an associated one of the channel candidates (CH1-CHN); and
    wherein the decision section (16, 17) determines that the received signal of the associated channel candidate (CH(k)) is not likely to be adequate for communications when a reception strength (RSSI', RSSI") of a received signal of each of the one or more frequencies in the vicinity of the frequencies of the channel candidates (CH1-CHN) is lower than that of a received signal of the frequency of the associated channel candidate by a predetermined value or by more than the predetermined value.

**6.** The communication apparatus according to any of claims 1 to 5,
wherein the frequencies in the vicinity of frequencies of the channel candidates (CH1-CHN) are set according to the reception strength (RSSI(k)) of the frequency reception signal of channel candidates (CH1-CHN).

**7.** A communication apparatus for performing multichannel transmission, comprising:

- a control section (16) for executing a predetermined system program and generating an instruction signal (S1, S2) for tuning to frequencies of channel candidates (CH1-CHN) and one or more frequencies in the vicinity of the frequencies of the channel candidates (CH1-CHN);
- a reception section (1; 2, 3) having a specific selection characteristic, for tuning to the frequencies of the channel candidates (CH1-CHN) and the one or more frequencies in the vicinity of the frequencies of the channel candidates in accordance with the instruction signal (S1, S2);
- a plurality of frequency converting sections (2, 3) including a first frequency converting section (2) for converting a frequency of a signal received by the reception section (1) to a first intermediate frequency (fIF1), and a second frequency converting section (3) for converting the first intermediate frequency (fIF1) to a second intermediate frequency (fIF2) lower than the first intermediate frequency (fIF1) and outputting a signal (Sx) indicating a reception level;
- a level determining circuit (15) for determining whether or not received signals of the channel candidates (CH1-CHN) are adequate for communications based on the reception-level indicating signal; and
- a memory (17) for storing various kinds of data at a time where the control section (16) performs preprocessing.

**8.** A communication method for use in a communication system for performing multichannel transmission by executing preprocessing for searching for an adequate channel for communications from a plurality of channels assigned to a radio frequency band and then setting a normal communication state, comprising the following steps:

- generating an instruction signal (S1, S2) for tuning to frequencies of channel candidates (CH1-CHN) and one or more frequencies in the vicinity of the frequencies of the channel candidates (CH1-CHN);

- tuning to the frequencies of the channel candidates (CH1-CHN) and the one or more frequencies in the vicinity of the frequencies of the channel candidates in accordance with a specific selection characteristic and the instruction signal (S1, S2);
- measuring (S206) a reception strength (RSSI(k)) of a signal (Sx) produced from a received signal; and
- determining (S208) whether or not received signals of the channel candidates (CH1-CHN) are adequate for communications based on reception strengths (RSSI(k)) of the received signals.

**9.** The communication method according to claim 8, wherein the selection characteristic is asymmetrical to a center frequency (fc1, fc2) and is such that an amount of attenuation in one frequency region with respect to the center frequency is smaller than an amount of attenuation in the other frequency region with respect to the center frequency (fc1, fc2).

**10.** The communication method according to claim 9, wherein a bandwidth of the frequency region, in which the amount of attenuation is smaller, is wider than a selected bandwidth in the close vicinity of the center frequency (fc1, fc2);
wherein each of the one or more frequencies in the vicinity of the frequencies of the channel candidates (CH1-CHN) is a frequency which has provided an associated one of the channel candidates with such a frequency difference that a difference in reception strength caused by a difference between the bandwidths can be detected (S402); and
wherein it is determined that a received signal of the associated channel candidate (CH(k)) is likely to be adequate for communications when the difference in reception strength is equal to or greater than a predetermined value (S404).

**11.** The communication method according to claim 9, wherein each of the one or more frequencies in the vicinity of the frequencies of the channel candidates (CH1-CHN) is acquired by subtracting a difference between a bandwidth of the frequency region, in which the amount of attenuation is smaller, and the center frequency (fc1, fc2) from a frequency of an associated one of the channel candidates; and
wherein it is determined that the received signal of the associated channel candidate (CH(k)) is adequate for communications when the reception strength of a received signal of each of the one or more frequencies in the vicinity of the frequencies of the channel candidates (CH1-CHN) is higher than that of a received signal of the frequency of the associated channel candidate by a predetermined value or by more than the predetermined value.

**12.** The communication method according to claim 9, wherein each of the one or more frequencies in the vicinity of the frequencies of the channel candidates (CH1-CHN) is acquired by adding a difference between a bandwidth of the frequency region, in which the amount of attenuation is smaller, and a bandwith of the other frequency region to a frequency of an associated one of the channel candidates; and

wherein it is determined that the received signal of the associated channel candidate is not likely to be adequate for communications (S308-S314), when a reception strength of a received signal of each of the one or more frequencies in the vicinity of the frequencies of the channel candidates (CH1-CHN) is lower than that of a received signal of the frequency of the associated channel candidate by a predetermined value or by more than the predetermined value.

# FIG.1

EP 1 035 649 A2

# FIG.2

```
                    START

SET COMMUNICATION APPARATUS TO
STANDBY MODE FOR COMMUNICATION WITH        S200
BASE STAIT ON OR SET IN TO
OUT-OF-RANGE STANDBY MODE

                    n=1          S202

            RECEIVE FREQUENCY fn OF      S204
            n-TH CHANNEL CHn

            MEASURE RSSIn        S206
            AT FREQUENCY fn

                                  S208
            RSSIn GREATER              YES
            THAN MINIMUM VALUE ?

                  NO
                                            S214
                      NO
                              RSSIn IN TOP k ?

                                  YES        S216

                        REORDER TOP k CHANNELS
                        IN THE ORDER OF HIGH-TO-LOW
                        LEVELS AND STORE THEM
                        AS CANDIDATES

                    n=n+1        S210

                                  S212
            NO    LAST CHANNEL CHN
                  CHECKED ?

                      YES

                        A
```

# FIG.3

(A)

k = 1 —S300

RECEIVE FREQUENCY f(k) OF CHANNEL CH(k) AND MEASURE RSSI(k) THEN —S302

S304— THD1 = 40dBµ ≦ RSSI(k)? —YES

NO

S306— THD2 = 20dBµ ≦ RSSI(k)? —YES

NO

S400— MEASURE
RSSI(+Δf) AT f(k)+Δf
RSSI(-Δf) AT f(k)-Δf
RSSI(+2Δf) AT f(k)+2Δf
RSSI(-2Δf) AT f(k)-2Δf

S402— $\Delta(+\Delta f) = RSSI(k) - RSSI(+\Delta f)$
$\Delta(-\Delta f) = RSSI(k) - RSSI(-\Delta f)$
$\Delta(+2\Delta f) = RSSI(k) - RSSI(+2\Delta f)$
$\Delta(-2\Delta f) = RSSI(k) - RSSI(-2\Delta f)$

S404— NO — Δ(+Δf), Δ(-Δf), Δ(+2Δf) AND Δ(-2Δf) ALL HIGHER THAN THD3?

S308
ESTIMATE THAT INTERFERENCE IS PRESENT IN AREA WITH POOR SELECTION CHARACTERISTIC

S406— YES
MEASURE EACH RSSI EVERY 0.5Δf IN A RANGE OF f(k)+300kHz TO f(k)+500kHz

S310— MEASURE RSSI' AT f(k)+800kHz AND RSSI" AT f(k)+700kHz

S312— RSSI' AND RSSI" BOTH LOWER THAN THD5 = 20dBµ? —NO

S314—
DETERMINE CHANNEL CH(k) AS INADEQUATE ONE

YES

S408— ANY DIFFERENCE BETWEEN EACH RSSI AND RSSI(k) LOWER THAN THD4? —YES

NO

S500—
DETERMINE CHANNEL CH(k) AS MOST ADEQUATE ONE

S316— ALL CHANNEL CANDIDATES CH(1)-CH(5) CHECKED? —NO

S318 k = k+1

YES

S320 DISPLAY THAT SETTING OPTIMAL COMMUNICATION STATE FAILED

S502
COMMUNICATE WITH BASE STATION

S504
COMMUNICATION SUCCESSFUL? —NO

YES

S506
COMMUNICATION STANDBY MODE

STOP

# FIG.4 A

| CHANNEL NO. | FREQUENCY (MHz) | RSSI (dB$\mu$) |
|---|---|---|
| $CH_1$ | $f_1$ | $RSSI_1$ |
| $CH_2$ | $f_2$ | $RSSI_2$ |
| $CH_3$ | $f_3$ | $RSSI_3$ |
| $CH_4$ | $f_4$ | $RSSI_4$ |
| ⋮ | ⋮ | ⋮ |
| $CH_n$ | $f_n$ | $RSSI_n$ |
| ⋮ | ⋮ | ⋮ |
| $CH_N$ | $f_N$ | $RSSI_N$ |

# FIG.4 B

| ORDER k | CHANNEL NO. CH(k) | FREQUENCY f(k) (MHz) | RSSI(k) (dB$\mu$) |
|---|---|---|---|
| 1 | $CH(1) = CH_3$ | $f(1) = f_3$ | $RSSI(1) = RSSI_3$ |
| 2 | $CH(2) = CH_{15}$ | $f(2) = f_{15}$ | $RSSI(2) = RSSI_{15}$ |
| 3 | $CH(3) = CH_{10}$ | $f(3) = f_{10}$ | $RSSI(3) = RSSI_{10}$ |
| 4 | $CH(4) = CH_n$ | $f(4) = f_n$ | $RSSI(4) = RSSI_n$ |
| 5 | $CH(5) = CH_2$ | $f(5) = f_2$ | $RSSI(5) = RSSI_2$ |

HIGH ↑ ↓ LOW

$$(RSSI)_2 < (RSSI)_n < (RSSI)_{10} < (RSSI)_{15} < (RSSI)_3$$

# FIG.5

AMOUNT OF
ATTENUATION
(dB)

THD3=70dB

TOTAL
CHARACTERISTIC

AREA WITH GOOD
CHARACTERISTIC

AREA WITH GOOD
CHARACTERISTIC

AREA WITH POOR
CHARACTERISTIC

$f_{c1}=130.05\text{MHz}$
$f_{c2}=450\text{kHz}$

DEVIATION (kHz)

(a)
(c)   (b)
(e)   (d)

EP 1 035 649 A2

# FIG.6

EP 1 035 649 A2

# FIG.7

AMOUNT OF ATTENUATION (dB)

DIFFERENCE

ARRA WITH POOR CHARACTERISTIC

AREA WITH GOOD CHARACTERISTIC

TOTAL CHARACTERISTIC

THD5=20dBμ

CHARACTERISTIC AT +700 kHz

CHARACTERISTIC AT +800 kHz

DEVIATION (kHz)

$f_{c1}$=130.05MHz

$f_{c2}$=450kHz

EP 1 035 649 A2

FIG.8

ANT

AMP1 $f_{rx}$

IF1

MIX1 $f_{IF1}$ BPF1 AMP2

OSC1 $f_{LO1}$

IF2

MIX2 $f_{IF2}$ BPF2 AMP3

OSC2 $f_{LO2}$

DEC

DEMODULATOR → OUTPUT

LDT

LEVEL DETERMINING CIRCUIT

RSSI

EP 1 035 649 A2

# FIG.9

# FIG.10

```
                    START

SET PORTABLE TELEPHONE TO          S100
STANDBY MODE FOR COMMUNICATION
WITH BASE STATION OR SET IT
TO OUT-OF-RANGE STANDBY MODE

SCAN ALL COMMUNICATION             S102
CHANNELS CH1 TO CHN AND
MEASURE INDIVIDUAL RSSI1
TO RSSIN

SELECT TOP k CHANNELS WITH         S104
HIGH-LEVEL RSSI AS CANDIDATES

MEASURE RSSI AGAIN FOR k           S106
CHANNEL CANDIDATES AND
SELECT CHANNEL WITH MAXIMUM
RSSI AS LIKELIEST CHANNEL
CANDIDATE

                                   S120
SELECT ONE OF
REMAINING CHANNELS
WHICH HAS
PROVIDED SECOND
HIGHEST RSSI AS
SECOND LIKELIEST
CHANNEL CANDIDATE

COMMUNICATE WITH BASE STATION      S108
OVER LIKELIEST CHANNEL CANDIDATE

        COMMUNICATION      S110    NO
        SUCCESSFUL?

        YES    S112

SET COMMUNICATION                  S114
STANDBY MODE               REMOVE CHANNELS
                           THAT FAILED
                           COMMUNICATION FROM
                           CHANNEL CANDIDATES

                             ALL           S116   NO
                           CANDIDATES
                            FAILED?

                              YES    S122

                           DISPLAY COMMUNICATION
                           FAILURE

                                STOP
```

22

# FIG.11

AMOUNT OF
ATTENUATION
(dB)

FIG.12

AMOUNT OF
ATTENUATION
(dB)

# FIG.13